# EUROPÄISCHE PATENTANMELDUNG

(11) **EP 1 455 560 A2**
(43) Veröffentlichungstag der Anmeldung: **08.09.2004**
(21) Anmeldenummer: 04002471.3
(22) Anmeldetag: 04.02.2004
(51) Int. Cl.: H05K 7/20

(54) **Schaltungsanordnung für zu kühlende Bauelemente und entsprechendes Kühlungsverfahren**

(30) Priorität: 07.03.2003 DE 10310141
(71) Anmelder: Patent-Treuhand-Gesellschaft für elektrische Glühlampen mbH, 81543 München (DE)
(72) Erfinder: Grabner, Martin, 83623 Dietramszell (DE); Witzani, Friedrich, 81477 München (DE)

(57) **Zusammenfassung**

Die Entwärmung von integrierten Leistungsbauelementen soll einfacher gestaltet werden. Hierzu wird eine Wärmeübertragungseinrichtung, insbesondere eine thermisch leitende Matte (3), zwischen die zu kühlenden Bauelemente (2) und einem Kern eines induktiven Bauelements (4) eingefügt. Die von den Leistungshalbleitem (2) produzierte Wärme kann somit an den Kern des induktiven Bauelements (4) abgegeben werden.

## Beschreibung

### Technisches Gebiet

Die vorliegende Erfindung betrifft eine Schaltungsanordnung mit einem zu kühlenden elektronischen Bauelement und einem induktiven Bauelement, das einen Kern besitzt. Darüber hinaus betrifft die vorliegende Erfindung ein entsprechendes Verfahren zum Kühlen eines elektronischen Bauelements.

### Stand der Technik

Integrierte Schaltkreise weisen häufig einen derart hohen Leistungsverbrauch auf, dass sie gekühlt werden müssen. Hierzu werden üblicherweise eigene Kühlmittel vorgesehen. Derartige Kühlmittel bestehen beispielsweise aus Kühlblechen oder Kühlkörpern, die verhältnismäßig voluminös sind. Bei sehr starker Wärmeabgabe können die elektronischen Bauelemente auch aktiv mittels eines Lüfters gekühlt werden. In jeden Fall ist eine ausreichende Kühlung nur gewährleistet, wenn das Kühlmittel genügend Energie aufnehmen kann. Dies bedeutet in der Regel, dass das Kühlmittel eine verhältnismäßig große Oberfläche besitzen muss, damit es die aufgenommene Wärme in ausreichender Menge auch wieder abgeben kann.

Bei vielen Anwendungen sollten jedoch die Schaltungsanordnungen aufgrund des geringen zur Verfügung stehenden Platzes möglichst kompakt gestaltet sein. Dementsprechend sollten auch die Kühlkörper möglichst klein gehalten werden.

### Darstellung der Erfindung

Die Aufgabe der vorliegenden Erfindung besteht somit darin, eine Schaltungsanordnung vorzuschlagen, bei der die Bauelemente auch bei sehr geringem Platzangebot ausreichend gekühlt werden können. Ferner sollte ein entsprechendes Kühlungsverfahren vorgeschlagen werden.

Erfindungsgemäß wird diese Aufgabe gelöst durch eine Schaltungsanordnung mit einem zu kühlenden Bauelement, einem an der Schaltungsanordnung aktiv beteiligten elektrischen Bauelement als Wärmesenke, insbesondere einem induktiven Bauelement mit Kern, sowie einer Wärmeübertragungseinrichtung, die zwischen dem zu kühlenden Bauelement und dem elektrischen Bauelement als Wärmesenke in unmittelbarem Kontakt zu beiden zur Entwärmung des zu kühlenden Bauelements angeordnet ist.

Darüber hinaus ist erfindungsgemäß vorgesehen ein Verfahren zum Kühlen eines elektronischen Bauelements einer elektrischen Schaltung durch Bereitstellen des zu kühlenden Bauelements der elektrischen Schaltung, Bereitstellen eines an der elektrischen Schaltung aktiv beteiligten elektrischen Bauelements als Wärmesenke, insbesondere eines induktiven Bauelements mit einem Kern, und Einfügen einer Wärmeübertragungseinrichtung zwischen das zu kühlende Bauelement und das als Wärmesenke dienende Bauelement in unmittelbarem Kontakt zu beiden zur Entwärmung des zu kühlenden Bauelements.

Auf diese Weise kann der Kern einer Induktivität, der eine verhältnismäßig große Wärmekapazität besitzt, als Kühl- oder Ausgleichskörper verwendet werden. Somit lässt sich ein speziell vorzusehender Kühlkörper einsparen und eine Schaltungsanordnung kompakter gestalten.

Vorzugsweise ist die Wärmeübertragungseinrichtung als Matte aus einem elastischen Material gefertigt. Damit kann die Kontaktoberfläche zwischen der Matte einerseits und dem zu kühlenden Bauelement oder dem Kern andererseits gewährleistet werden, wenn das Bauelement an den Kern gepresst wird. Eine derartig elastische Matte kann aus einer geschäumten Masse hergestellt werden.

Das induktive Bauelement kann einen Transformator umfassen. Der Kern des Transformators besitzt üblicherweise eine große Masse und damit auch eine entsprechend hohe Wärmekapazität, um als Wärmesenke zu dienen.

Das zu kühlende Bauelement kann eine integrierte Schaltung und insbesondere ein Leistungsbauelement sein. Deren flächige Bauweise begünstigt den Wärmetransport zu der thermischen Matte.

Die Schaltungsanordnung kann über mehrere zu kühlende Bauelemente verfügen, über die die Matte gemeinsam gelegt ist. Damit kann die Kühlung mehrerer Bauelemente gleichzeitig vonstatten gehen.

### Kurze Beschreibung der Zeichnungen

Die vorliegende Erfindung wird nun anhand der beigefügten Zeichnungen näher erläutert, in denen zeigen:
- Figur 1: eine Draufsicht auf Leistungshalbleiter, die auf eine Platine gelötet sind;
- Figur 2: eine Draufsicht auf die erfindungsgemäße Matte, unter der die Leistungshalbleiter von Figur 1 angeordnet sind;
- Figur 3: eine perspektivische Ansicht der Anordnung von Figur 2;
- Figur 4: eine Seitenansicht der Anordnung von Figur 2 mit darüber montiertem Transformator; und
- Figur 5: eine Stirnseitenansicht der Anordnung von Figur 4.

### Bevorzugte Ausführung der Erfindung

Das nachfolgend näher beschriebene Ausführungsbeispiel stellt eine bevorzugte Ausführungsform der vorliegenden Erfindung dar.

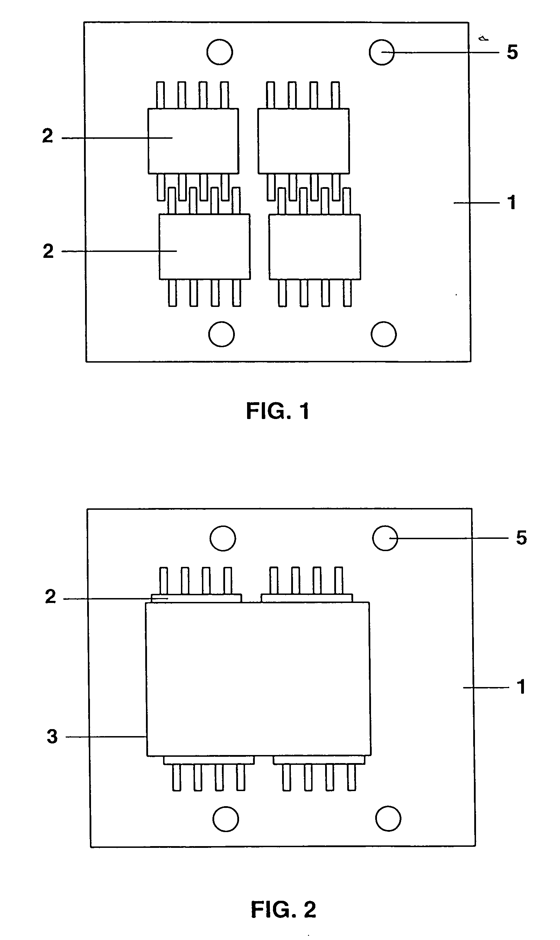

Auf einer Leiterplatine 1 sind in unmittelbarer Nähe zueinander mehrere integrierte Schaltungen mit Leistungshalbleitern 2 (kurz Leistungshalbleiter) aufgelötet, wie dies in der Draufsicht von Figur 1 zu sehen ist. Die Leistungshalbleiter 2 haben einen Energieverbrauch, der spezielle Kühlmaßnahmen erfordert.

Die vier Leistungshalbleiter 2 sind im vorliegenden Fall in sogenannte SO8 Gehäuse integriert. Diese weisen jeweils eine ebene Oberfläche auf, die zusammen in einer Ebene liegen. Auf die Leistungshalbleiter 2 kann daher ohne weiteres eine thermisch leitfähige Matte 3 platziert werden, wie dies in Figur 2 dargestellt ist.

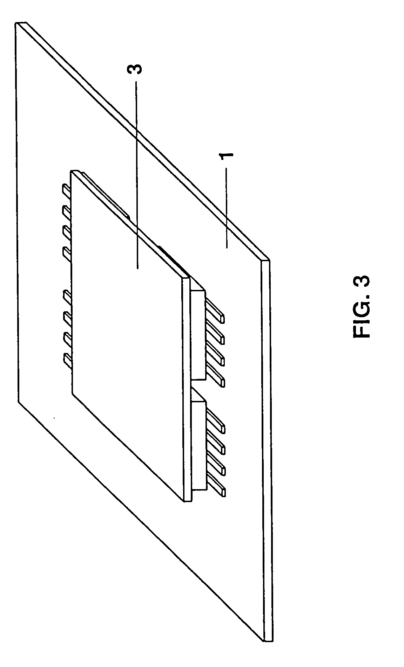

Figur 3 zeigt hierzu eine perspektivische Ansicht. Die aus einem geschäumten, elektrisch isolierendem Material bestehende, wärmeleitfähige Matte 3 überdeckt sämtliche zu kühlende integrierte Schaltkreise 2. Die Matte 3 kann aus Stabilitätsgründen oder Gründen des Wärmeübergangs an der Oberfläche eine spezielle Beschichtung aufweisen.

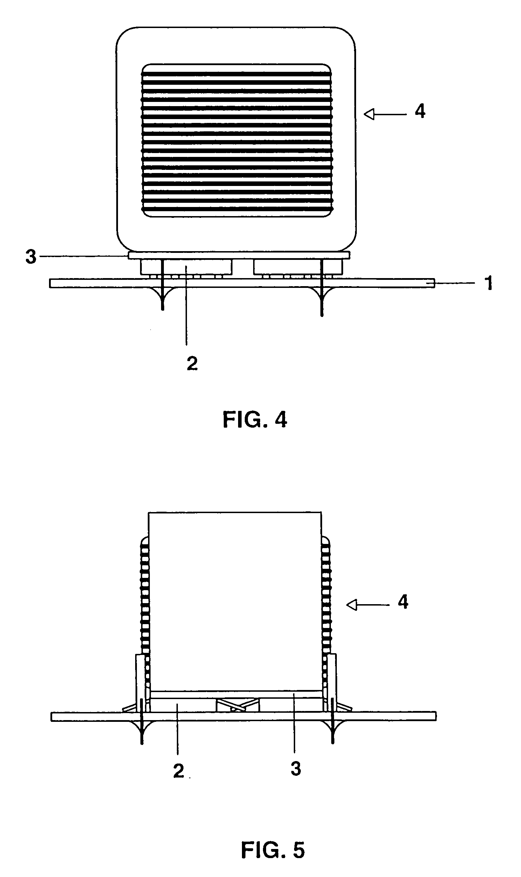

Figur 4 zeigt nun einen Transformator, der auf die Leistungshalbleiter 2 mit der darüber liegenden Matte 3 gepresst ist. Der Transformator 4 wird in den Bohrungen 5 (vergleiche Figur 1) der Leiterplatine 1 durch Löten fixiert und kontaktiert.

Der aus Ferrit gefertigte Kern des Transformators 4 drückt damit auf die Matte 3 und die darunter liegenden Leistungshalbleiter 2, so dass zwischen den Leistungshalbleitern 2 und dem Ferritkern ein verbesserter Wärmeübergang gewährleistet ist.

Figur 5 zeigt diese Montageanordnung nochmals in Stirnseitenansicht. Deutlich ist in dieser Ansicht noch einmal zu sehen, dass die Matte 3 an ihrer Oberfläche eine spezielle Beschichtung besitzt. Darüber hinaus wird deutlich, dass durch diese Kühlanordnung eine sehr kompakte Bauweise realisiert werden kann, wobei auf einen zusätzlichen Kühlkörper verzichtet werden kann, da der Ferritkern des Transformators 4 die Kühlfunktion übernimmt.

Bei einer alternativen Bauform kann anstelle der thermisch leitenden Matte 3 ein Kunststoffmaterial zwischen den Kern des Transformators 4 und die Leistungshalbleiter 2 als Wärmeübertragungseinrichtung gespritzt werden. Dies hätte den weiteren Vorteil, dass die Leistungshalbleiter auf einer noch größeren Fläche mit dem thermisch leitenden Material umgeben wären.

## Patentansprüche

1. Schaltungsanordnung mit
einem zu kühlenden Bauelement (2),
**gekennzeichnet durch**
ein an der Schaltungsanordnung aktiv beteiligtes elektrisches Bauelement als Wärmesenke, insbesondere ein induktives Bauelement (4) mit Kern, und
eine Wärmeübertragungseinrichtung (3), die zwischen dem zu kühlenden Bauelement (2) und dem elektrischen Bauelement als Wärmesenke in unmittelbarem Kontakt zu beiden zur Entwärmung des zu kühlenden Bauelements (2) angeordnet ist.

2. Schaltungsanordnung nach Anspruch 1, wobei die Wärmeübertragungseinrichtung (3) eine elastische Matte umfasst.

3. Schaltungsanordnung nach Anspruch 2, wobei die Matte aus einer geschäumten Masse gefertigt ist.

4. Schaltungsanordnung nach einem der Ansprüche 1 bis 3, wobei das induktive Bauelement (4) ein Transformator ist.

5. Schaltungsanordnung nach einem der Ansprüche 1 bis 4, wobei das zu kühlende Bauelement (2) eine integrierte Schaltung ist.

6. Schaltungsanordnung nach einem der Ansprüche 1 bis 5, die mehrere zu kühlende Bauelemente (2), über die die Wärmeübertragungseinrichtung (3) gemeinsam angeordnet ist, besitzt.

7. Verfahren zum Kühlen eines elektronischen Bauelements (2) einer elektrischen Schaltung durch
Bereitstellen des zu kühlenden Bauelements (2) der elektrischen Schaltung,
**gekennzeichnet durch**
Bereitstellen eines an der elektrischen Schaltung aktiv beteiligten elektrischen Bauelements als Wärmesenke, insbesondere eines induktiven Bauelements (4), das einen Kern besitzt, und
Einfügen einer Wärmeübertragungseinrichtung (3) zwischen das zu kühlende Bauelement (2) und das als Wärmesenke dienende Bauelement in unmittelbarem Kontakt zu beiden zur Entwärmung des zu kühlenden Bauelements (2).

8. Verfahren nach Anspruch 7, wobei die Wärmeübertragungseinrichtung (3) eine elastische Matte umfasst.

9. Verfahren nach Anspruch 8, wobei die Matte aus einer geschäumten Masse gefertigt ist.

10. Verfahren nach einem der Ansprüche 7 bis 9, wobei das induktive Bauelement (4) ein Transformator ist.

11. Verfahren nach einem der Ansprüche 7 bis 10, wobei das zu kühlende Bauelement (2) eine integrierte Schaltung ist.

12. Verfahren nach einem der Ansprüche 7 bis 11, wobei mehrere zu kühlende Bauelemente (2) bereitgestellt werden, die gemeinsam mit Hilfe der Wärmeübertragungseinrichtung (3) an dem als Wärmesenke dienenden Bauelement gekühlt werden.
